# FASCICULE DE BREVET EUROPEEN

(11) **EP 0 845 783 B1**
(45) Date de publication et mention de la délivrance du brevet: **02.02.2000**
(21) Numéro de dépôt: 97470031.2
(22) Date de dépôt: 27.11.1997
(51) Int. Cl.: G11C 7/06

(54) **Circuit de lecture pour mémoire**
Speicherleseschaltung
Read circuit for memory

(30) Priorité: 28.11.1996 FR 9614775
(43) Date de publication de la demande: 03.06.1998
(73) Titulaire: STMicroelectronics S.A., 94250 Gentilly (FR)
(72) Inventeur: Ferrant, Richard, 57000 Metz (FR)
(74) Mandataire: Ballot, Paul Denis Jacques

(56) Documents cités:
- EP-A- 0 488 327
- IZUMIKAWA ET AL: "a current direction sense technique for multiport sram's" IEICE TRANS.ELECTRON., vol. e79, no. 7, juillet 1996, pages 957-962, XP000632350
- WATANABE: "offset compensating bit line sensing for high density drams" IEEE JOURNAL OF SOLID STATE CIRCUITS, vol. 29, no. 1, janvier 1994, NEW YORK; US, pages 9-13, XP000441632

## Description

L'invention concerne les mémoires en circuit intégré et, plus particulièrement, les circuits de lecture permettant de détecter l'état des cellules d'une mémoire.

Les mémoires sont, classiquement, organisées en matrices de cellules de mémorisation. Les cellules d'une même colonne étant reliées à une ou des lignes de bit. Dans les mémoires non volatiles (ROM, EPROM, EEPROM, Flash EPROM) les cellules sont reliées à une ligne de bit. Dans les mémoires statiques à accès aléatoire (SRAM) ces cellules sont reliées à deux lignes de bit complémentaires l'une de l'autre. Les cellules d'une même rangée sont reliées à une ligne de mot. La ligne de bit (ou les lignes de bit complémentaires) permet de transmettre une information sur l'état d'une cellule de mémorisation située au croisement de cette ligne de bit et d'une ligne de mot sélectionnée.

Les circuits de lecture sont reliés aux lignes de bit des colonnes, éventuellement par l'intermédiaire d'un multiplexeur si on utilise un circuit de lecture pour plusieurs colonnes. Typiquement, la lecture d'une cellule consiste à produire un signal logique représentatif de la valeur d'un courant électrique traversant cette cellule, valeur qui dépend de l'état de la cellule. Si on considère, par exemple, une mémoire non volatile, les cellules peuvent avoir un état dit vierge (ou dit programmé, selon la convention choisie) dans lequel elles peuvent laisser passer un courant et un état dit programmé (ou dit vierge, selon la convention choisie) dans lequel elles s'opposent au passage du courant. Pour lire l'information sur l'état d'une cellule, on utilise la capacité équivalente de la ligne de bit à laquelle est reliée cette cellule. Cette capacité est généralement de l'ordre de grandeur du picofarad. On cherche à détecter la présence d'un courant de charge ou de décharge de la ligne de bit reliée à la cellule.

Généralement, on utilise une lecture différentielle. Dans les mémoires non volatiles, on utilise ainsi, généralement, une ligne de référence semblable à la ligne de bit, cette ligne de référence conduisant un courant de référence pendant la lecture. Dans les mémoires SRAM, on utilise les deux lignes de bit complémentaires reliées aux cellules. La lecture se fait en comparant, avec un amplificateur différentiel, les potentiels présents d'une part sur la ligne de bit et, d'autre part, sur la ligne de référence ou sur la ligne de bit complémentaire, ces potentiels variant selon que l'on charge ou que l'on décharge ces lignes.

Un problème posé par ce type de circuit est l'influence de la valeur de la charge capacitive équivalente de la ou des lignes sur le temps d'accès en lecture au contenu des cellules. Cette charge capacitive équivalente est liée aux paramètres géométriques des lignes et à l'état des cellules reliées à ces lignes. Plus cette charge est importante et plus le temps nécessaire pour la lecture est important. Comme le temps d'accès est variable, on ne peut être certain qu'une lecture ait été effectuée qu'après qu'un délai correspondant à la lecture à charge équivalente maximale théorique, même si la lecture peut être, en pratique, plus rapide.

Il faut également tenir compte des différences de charge capacitive entre les lignes. Si les lignes sont chargées différemment, les délais de stabilisation des potentiels sur ces lignes sont différents. Outre les délais de stabilisation des potentiels, il convient également de prendre en compte l'influence de la différence de charge sur le fonctionnement du dispositif de lecture relié aux lignes. Si le dispositif est sensible à cette influence, il est nécessaire de prévoir une marge temporelle supplémentaire dans le temps d'accès garanti en lecture.

Enfin, une tendance actuelle est de proposer des circuits modulables et, notamment, comprenant des mémoires de tailles adaptées aux applications. En pratique, l'influence de la charge capacitive oblige à adapter l'implémentation des circuits de lecture au cas par cas, en tenant compte de la taille de la mémoire à réaliser.

L'amplificateur de lecture divulgué dans "A current direction sense technique for Multiport Sram's", IZUMIKAWA ET AL, IEICE TRANS.ELECTRON., vol. e79, no. 7, Juillet 1996, pages 957-962, XP000632350 est commandé par un potentiel IN, représentant le potentiel sur la ligne de bit. Un amplificateur différentiel réagit au sens du courant fournit ou reçu par l'inverseur d'entrée.

Un but de l'invention est de proposer un circuit de lecture amélioré qui minimise l'influence de la charge capacitive de ligne.

Pour ce faire, on propose d'utiliser un circuit de lecture effectuant une mesure en courant. Plus précisément, on propose de détecter la présence ou non d'un courant dans une cellule, la ligne restant chargée à un potentiel sensiblement stable.

Ainsi, l'invention concerne un circuit de lecture pour mémoire comprenant au moins une première entrée pour être reliée à une ligne de bit à laquelle sont raccordées des cellules de mémoire et une sortie pour produire un potentiel logique de sortie. Une source de courant produit un premier courant. Un convertisseur courant - tension produit le potentiel logique de sortie, ce potentiel étant représentatif de la valeur d'un second courant, obtenu par déviation d'une partie du premier courant vers la ligne de bit quand on lit l'une des cellules, de sorte qu'une fois la ligne de bit chargée, la valeur de ce second courant soit déterminée par le seul état de la cellule sélectionnée et soit indépendante de la charge capacitive de la ligne de bit.

D'autres avantages et particularités apparaîtront à la lecture de la description qui suit d'un exemple de réalisation de l'invention, à lire conjointement aux dessins annexés dans lesquels :
- la figure 1 représente un circuit de lecture réalisé conformément à l'invention.
- la figure 2 représente un exemple détaillé de réalisation d'un circuit de lecture selon l'invention,
- la figure 3 représente un exemple de mise en oeuvre du circuit de la figure 2.

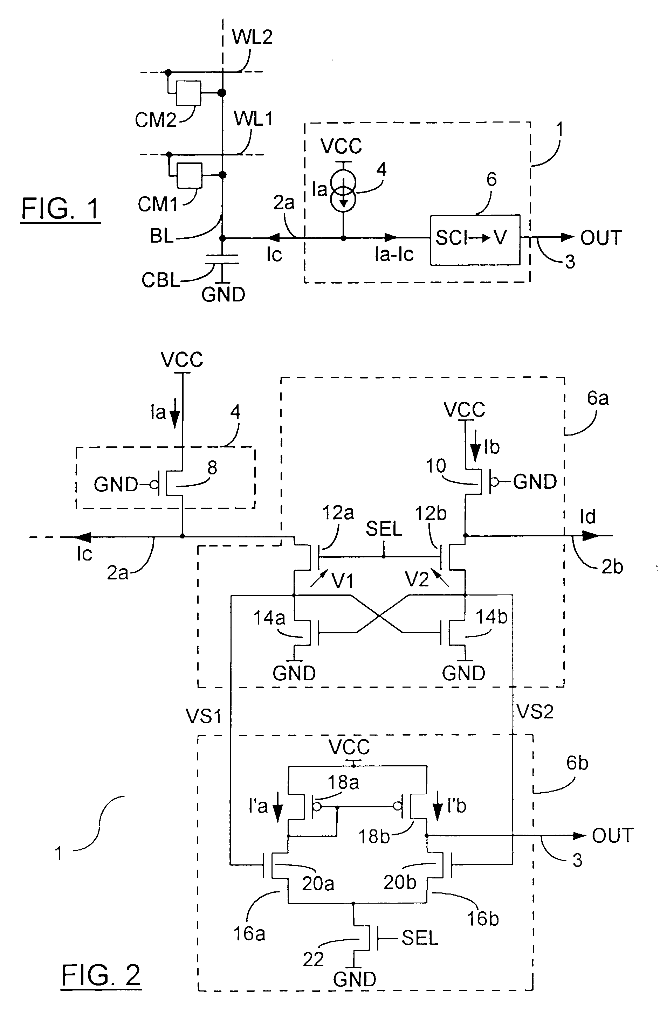

La figure 1 représente un circuit de lecture 1 réalisé conformément à l'invention.

Il comprend une entrée 2a et une sortie 3, une source de courant 4 et un convertisseur courant - tension 6. La source 4 produit un courant Ia. La sortie 3 fournit un potentiel logique de sortie OUT.

La source de courant 4 est montée entre l'entrée 2a et une borne d'alimentation recevant un potentiel d'alimentation VCC. Le convertisseur 6 a une entrée reliée à l'entrée 2a et une sortie produisant le potentiel OUT.

La source de courant fournit un courant Ic à l'entrée 2a et un courant Ia - Ic au convertisseur. La valeur du potentiel de sortie OUT est représentatif de la valeur du courant Ia - Ic et fournit une information sur l'état des cellules lues, la valeur du courant Ic étant représentatif de l'état des cellules lues.

Pour pouvoir lire le contenu de cellules CM1, CM2 ... reliées à une ligne de bit BL et à des lignes de mot WL1, WL2 ..., on relie la ligne de bit BL à l'entrée 2a. Cette ligne de bit présente une capacité équivalente, représentée sur la figure 1 par une capacité CBL montée entre l'entrée 2a et une masse, de potentiel noté GND.

Supposons que la capacité CBL soit chargée. Elle présente à ses bornes une tension sensiblement égale à VCC. Si on lit une cellule qui laisse passer un courant, alors on aura Ia - Ic < Ia. Si la cellule ne laisse pas passer de courant, on a Ia - Ic = Ia. La capacité équivalente de la ligne à laquelle les cellules sont reliées, une fois chargée à VCC, ne varie pas. On assure donc un temps d'accès très rapide et indépendant de la valeur de la capacité équivalente de la ligne.

La figure 2 représente un exemple détaillé de réalisation du circuit de lecture 1 réalisé conformément à l'invention.

Il comprend une deuxième entrée 2b. Comme on le verra ultérieurement, le circuit illustré sur la figure 2 permet de réaliser éventuellement une lecture différentielle.

La source de courant 4 comprend un transistor 8, de type MOS à canal P, dont la grille de commande reçoit un potentiel constant permettant de réguler le courant le traversant. Dans l'exemple, on suppose que la grille reçoit le potentiel GND. Le transistor 8 reçoit le potentiel VCC sur sa source. Son drain est relié à l'entrée 2a.

Le convertisseur courant - tension 6 comprend un premier étage 6a de conversion courant - tension et un deuxième étage 6b de conversion tension - tension. Le premier étage 6a produit une différence de potentiel VS2 - VS1 à partir du courant Ic fourni à la sortie 2a par le transistor 8. Le second étage 6b produit le potentiel de sortie OUT à partir de la différence de potentiel VS2 - VS1.

Le premier étage 6a comprend une source de courant fournissant un courant de référence Ib. Dans l'exemple illustré, la source de courant de l'étage 6a est réalisée en utilisant un transistor 10, de type MOS à canal P. La grille de commande de ce transistor est au potentiel GND et sa source est au potentiel haut VCC.

L'étage 6a comprend outre deux transistors 12a et 14a, de type MOS à canal N, montés en série entre un noeud recevant le potentiel GND et le drain du transistor 8. Il comprend également deux transistors 12b et 14b, de type MOS à canal N, montés en série entre un noeud recevant le potentiel GND et le drain du transistor 10.

Les drains des transistors 12a et 12b sont reliés aux drains des transistors 8 et 10. Les transistors 12a et 12b sont utilisés, concurremment avec les transistors 14a et 14b, en convertisseurs courant - tension. Les grilles de commande des transistors 12a et 12b reçoivent un potentiel de commande SEL. De préférence, le potentiel SEL est variable et permet rendre les transistors passants ou bloqués selon sa valeur. Le potentiel SEL sera, par exemple, égal à VCC pour rendre les transistors passants et égal à GND pour les rendre bloqués. Les transistors 12a et 12b sont alors également utilisés comme transistors de sélection. Quand le circuit de lecture est utilisé pour lire des cellules, ces transistors sont passants. Quand le circuit de lecture n'est pas utilisé, ces transistors sont bloqués. Cela permet de couper la consommation de l'étage 6a, ce qui est avantageux pour les mémoires dites embarquées qui sont alimentées par des batteries. On peut ne pas utiliser les transistors 12a et 12b comme transistors de sélection. Dans ce cas, le potentiel SEL peut être fixe et on le choisit de sorte que ces transistors soient passants.

Le drain du transistor 12a correspond à l'entrée 2a. Les transistors 12a et 14a sont parcourus par le courant Ia - Ic. Les drains des transistors 10 et 12b correspondent à l'entrée 2b. On note Id le courant fourni par le transistor 10 à l'entrée 2b. Les transistors 12b et 14b sont parcourus par un courant Ib - Id.

Les drains des transistors 14a et 14b sont reliés aux sources des transistors 12a et 12b. Les grilles de commande des transistors 14a et 14b sont respectivement reliées au drain du transistor 14b et au drain du transistor 14a. Leurs sources sont au potentiel GND. On note VS le potentiel du drain du transistor 14a et VS2 le potentiel du drain du transistor 14b. Les potentiels VS1 et VS2, de valeur comprise entre VCC et GND, sont les potentiels fournis au deuxième étage 6b pour produire le potentiel de sortie OUT.

De préférence les transistors 8 et 10 sont appariés. Les transistors 12a et 12b, d'une part, et 14a et 14b, d'autre part, sont de préférence appariés deux à deux de sorte que les branches formées des triplets de transistors (8, 12a, 14a) et (10, 12b, 14b) soient identiques. Par ailleurs, on choisira des transistors 12a et 12b qui soient identiques aux transistors 14a et 14b ou de taille légèrement inférieure pour compenser leur tension de seuil, légèrement supérieure à taille identique, du fait de l'effet substrat.

L'étage 6b est un amplificateur différentiel classique. Il comprend deux branches 16a et 16b. Les branches sont parcourues par des courants l'a et I'b fournis par un miroir de courant de type classique. Le miroir de courant est formé de deux transistors 18a et 18b, de type MOS à canal P, dont les sources sont au potentiel VCC et dont les grilles de commande sont reliées entre elles. La grille de commande et le drain du transistor 18a, qui sert de transistor de référence, sont reliées entre eux. Ce transistor fourni le courant l'a. Le transistor 18b, qui sert de transistor de recopie, fournit le courant I'b.

Les branches 16a et 16b comprennent des transistors 20a et 20b, de type MOS à canal N, formant une paire différentielle. Les drains de ces transistors sont reliés respectivement aux drains des transistors 18a et 18b. Leurs sources sont reliées, d'une part, entre elles et, d'autre part, à un noeud porté au potentiel GND, par le biais d'un transistor 22. Le transistor 22 est un transistor de type MOS à canal N. Il reçoit sur sa grille de commande un potentiel de commande permettant de le rendre passant ou bloqué. Dans l'exemple, le transistor 22 reçoit le potentiel SEL. Le transistor 22, optionnel, permet de couper la consommation de l'étage 6b quand le circuit 1 n'est pas utilisé. Les grilles de commande des transistors 20a et 20b sont reliées, respectivement, aux drains des transistors 14a et 14b et reçoivent les potentiels VS1 et VS2. La sortie 3 du circuit 1 correspond au drain du transistor 20b.

On va maintenant décrire le fonctionnement du circuit de lecture 1 illustré sur la figure 2 en supposant, en premier lieu, qu'on l'utilise pour lire une mémoire de type non volatile, dans lesquelles les cellules sont formées de transistors passants ou bloqués selon la nature de l'information stockée par ces cellules. Ces cellules sont reliées à des lignes de bit. Pour lire les cellules d'une ligne de bit, on relie cette ligne à l'entrée 2a.

On suppose que le miroir de courant de l'étage 6b est de rapport inférieur à 1 (I'a > I'b) de telle sorte que le potentiel OUT est égal au potentiel VCC (correspondant typiquement à un état logique haut) quand les potentiels VS1 et VS2 sont identiques.

Supposons que le circuit de lecture soit sélectionné (les transistors 12a, 12b et 22 sont alors passants). Une fois que la capacité équivalente de la ligne de bit est chargée, on a Ia - Ic = Ia = Ib tant qu'aucune cellule de la ligne de bit n'est sélectionnée par la ligne de mot qui lui correspond. Soit V1 la tension grille - source du transistor 12a et V2 la tension grille - source du transistor 12b, on a alors V1 = V2 et VS1 = VS2.

Si on sélectionne une cellule de la ligne de bit et si cette cellule est passante (état vierge), un courant Ic non nul, fourni par le transistor 8, traverse cette cellule. Le transistor 12a est alors parcouru par un courant Ia - Ic inférieur à Ib. En conséquence, la tension V1 va augmenter. Le potentiel SEL étant constant, le potentiel VS1 de la source du transistor 12a et de la grille de commande du transistor 14b augmente. Le potentiel VS2 de la grille de commande du transistor 14a et de la source du transistor 12b va, au contraire, chuter. Parallèlement, le potentiel OUT chute et atteint la valeur du potentiel GND (correspondant typiquement à un état logique bas).

Le miroir formé par les transistors 18a et 18b est déséquilibré de sorte qu'il n'y ait pas d'indétermination du potentiel sur la sortie 3 quand les potentiels VS1 et VS2 sont identiques (c'est le cas si on lit une cellule ne laissant pas passer de courant, Ic = 0). Dans ce cas, le potentiel OUT reste à la valeur du potentiel VCC.

Si on utilise le circuit de lecture pour lire des cellules accessibles par le biais de deux lignes de bit complémentaires (cas des mémoires SRAM, par exemple), on utilise les deux entrées 2a et 2b, chacune d'entre elles étant reliée à l'une des lignes. On pourra alors utiliser un miroir équilibré dans l'étage 6b, puisqu'il ne peut alors pas y avoir d'équilibre des entrées 2a et 2b.

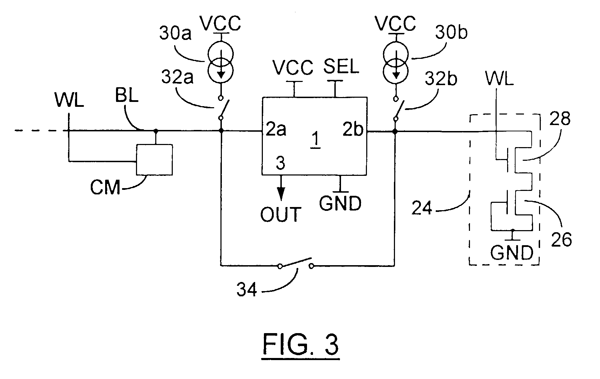

La figure 3 illustre un exemple d'application du circuit 1 de la figure 2, dans le cas où on lit une mémoire ROM ou de type EPROM.

L'entrée 2a est relie à une ligne de bit BL, celle-ci permettant d'accéder à une cellule CM quand elle est sélectionnée par une ligne de mot WL.

L'entrée 2b est reliée à un circuit de référence 24. Sur la figure 3, le circuit 24 comprend un transistor 26, de type MOS à canal N, relié à l'entrée 2b par le biais d'un transistor de sélection 28, de type MOS à canal N, ayant sa grille de commande reliée à la ligne de mot WL. La source et la grille de commande du transistor 24 reçoivent le potentiel GND. Le circuit 24 se comporte donc comme une cellule ne déviant pas de courant.

L'utilisation d'un circuit de référence permet de minimiser l'effet des couplages capacitifs induits par le croisement des lignes de mot et de bit associées à la cellule CM, en reproduisant ce croisement sur la deuxième entrée 2b.

On pourra éventuellement commander le transistor 24 de sorte qu'il laisse passer un courant intermédiaire, de valeur comprise entre les valeurs minimales et maximales pouvant être prises par le courant dans une cellule sélectionnée (valeurs correspondants aux états des cellules). Cela permet de s'affranchir différemment de l'indétermination entre les entrées 2a et 2b quand une cellule sélectionnée ne laisse pas passer de courant, tel que décrit en référence à la figure 2 (indétermination levée en déséquilibrant le miroir de l'étage 6b, quand l'entrée 2b n'est pas utilisée).

On pourra également utiliser des dispositifs de précharge et d'équilibrage de la ou des lignes reliées aux entrées du circuit de lecture. Ainsi, sur la figure 3, on a représenté des sources de courant 30a et 30b reliées aux entrées 2a et 2b par le biais de deux interrupteurs 32a et 32b. L'emploi de sources 30a et 30b fournissant un courant important permet de charger rapidement les charges capacitives présentes sur les entrées 2a et 2b. Une fois chargées, on isole ces sources des entrées et la lecture peut s'effectuer avec de faibles courants, de l'ordre de grandeur de la centaine de microampères. En l'absence de telles sources 30a et 30b, la charge des entrées est réalisée par le biais des sources de courant du circuit de lecture. Par ailleurs, on a représenté un interrupteur permettant de relier les deux entrées 2a et 2b entre elles. Ainsi, on peut équilibrer les potentiels de ces entrées avant la lecture et diminuer le temps de réaction du circuit de lecture.

Le circuit de lecture décrit permet de lire l'état des cellules en ne fournissant à la ligne de bit que le courant pouvant les traverser. En effet, le potentiel de la ligne ne varie pas, une fois celle-ci chargée, et ce quel que soit le nombre de cellules sélectionnées successivement. La valeur absolue de la charge capacitive équivalente de la ligne n'a donc pas d'impact sur le temps d'accès aux cellules. On peut garantir un temps d'accès indépendant de la taille de la ligne de bit, du moins tant que la résistance de la ligne peut être négligée (en pratique cela correspond à un nombre de cellules très important, de l'ordre de grandeur du millier). Le circuit de lecture pourra donc être utilisé pour des mémoires de taille variable, sans modifier le temps de lecture. On n'aura pas à adapter le circuit de lecture au cas par cas, ce qui simplifie la tâche des concepteurs de circuits dédiés.

Par ailleurs, le fait qu'on puisse lire le contenu de plusieurs cellules d'une ligne en ne chargeant qu'une seule fois cette ligne permet de diminuer la consommation du circuit de lecture en comparaison avec les circuits de lecture basés sur une lecture du potentiel de la ligne. Comme on l'a vu, on peut en effet limiter le courant de fonctionnement du premier étage à quelques centaines de microampères, ce qui est très avantageux pour les mémoires embarquées. En outre, la lecture étant faite en courant, le circuit proposé est moins sensible au bruit parasite sur les alimentations.

Dans l'hypothèse où les deux entrées 2a et 2b sont utilisées, cette indépendance de la lecture en fonction des charges capacitives sur les entrées permet d'ignorer la différence de charge entre ces entrées. On pourra donc garantir un temps d'accès plus rapide au contenu des cellules.

Dans le cas des mémoires sans ligne de bit complémentaire, l'invention permet d'utiliser un circuit de lecture sans ligne de référence, une seule entrée étant alors utilisée. Cela permet de faciliter la conception des circuits et de diminuer l'encombrement des mémoires.

## Revendications

1. Circuit (1) de lecture pour mémoire comprenant :
- au moins une première entrée (2a) pour être reliée à une ligne de bit (BL) à laquelle sont raccordées des cellules de mémoire (CM1, CM2),
- une sortie (3) pour produire un potentiel logique (OUT) de sortie,
- une source de courant (4) produisant un premier courant (Ia), et
- un convertisseur courant - tension (6) produisant le potentiel logique de sortie (OUT), ce potentiel étant représentatif de la valeur d'un second courant (Ia - Ic), obtenu par déviation d'une partie (Ic) du premier courant (Ia) vers la ligne de bit (BL) quand on lit l'une des cellules, de sorte qu'une fois la ligne de bit chargée, la valeur de ce second courant (Ia - Ic) soit déterminée par le seul état de la cellule sélectionnée et soit indépendante de la charge capacitive (CBL) de la ligne de bit.

2. Circuit selon la revendication 1, caractérisé en ce que le convertisseur courant - tension comprend :
- un premier étage (6a) de conversion courant - tension, ledit premier étage produisant à partir du second courant (Ia - Ic) une différence de potentiel (VS2 - VS1) représentative de la valeur de ce second courant et
- un second étage (6b) de conversion tension - tension, recevant la différence de potentiel du premier étage et produisant le potentiel logique de sortie (OUT).

3. Circuit selon la revendication 2, caractérisé en ce qu'il comprend une seconde entrée (2b) pour être reliée à un circuit de référence, le premier étage (6a) produisant un courant de référence (Ib), la différence de potentiel étant produite en fonction des valeurs relatives du second courant (Ia - Ic) et d'un troisième courant (Ib - Id) obtenu par déviation d'une partie (Id) du courant de référence (Ib) vers la ligne de référence.

4. Circuit selon l'une des revendications 2 ou 3, caractérisée en ce que le premier étage (6a) comprend :
- une première branche, ladite première branche comprenant au moins deux premiers transistors (12a, 14a) montés en série avec la première source de courant (4), et produisant un premier potentiel (VS1) représentatif du courant (Ia - Ic) traversant les dits premiers transistors, et
- une seconde branche, ladite seconde comprenant une seconde source de courant à (10) produisant le courant de référence (Ib) et au moins deux seconds transistors (12b, 14b) montés en série avec la seconde source de courant, et produisants un second potentiel (VS2) représentatif du courant (Ib - Id) traversant les dits seconds transistors.

5. Circuit selon les revendications 3 et 4, caractérisé en ce que pour chaque branche, l'un des transistors (12a, 12b) a son canal parcouru respectivement par le second (Ia - Ie) et le troisième (Ib - Id) courant, leurs grilles de commande étant à un potentiel donné (SEL), et leurs sources produisant les premier et second potentiels (VS1, VS2).

6. Circuit selon l'une des revendications 3 à 5, caractérisé en ce que le second étage (6b) du convertisseur est une paire différentielle déséquilibrée de telle sorte que le potentiel de sortie (OUT) produit ait une première valeur quand le second courant (Ia - Ic) et le troisième courant (Ib - Id) sont égaux et qu'il ait une deuxième valeur quand ils sont différents.

## Patentansprüche

1. Leseschaltung (1) für Speicher, die aufweist:
- mindestens einen ersten Eingang (2a), der an eine Bitleitung (BL) angeschlossen ist, die mit Speicherzellen (CM1, CM2) verbunden ist,
- einen Ausgang, an dem eine logische Ausgangsspannung (OUT) anliegt,
- eine Stromquelle (4), die einen ersten Strom (Ia) erzeugt, und
- einen Strom-Spannungs-Wandler (6), der die logische Ausgangsspannung (OUT) erzeugt, wobei diese Spannung den Wert eines zweiten Stroms (Ia-Ic) darstellt, die durch Umleitung eines Teils (Ic) des ersten Stroms (Ia) zur Bitleitung (BL) erzeugt wird, wenn eine der Zellen gelesen wird, so daß der Wert des zweiten Stroms (Ia-Ic) nur durch den Zustand der ausgewählten Zelle bestimmt und von der kapazitiven Ladung (CBL) der Bitleitung unabhängig ist, sobald die Bitleitung beaufschlagt wurde.

2. Leseschaltung nach Anspruch 1,
dadurch gekennzeichnet, daß
der Strom-Spannungs-Wandler aufweist:
- eine erste, als Strom-Spannungs-Wandler wirkende Stufe (6a), die aus dem zweiten Strom (Ia-Ic) eine Spannungsdifferenz (VS2-VS1) erzeugt, die den Wert des zweiten Stroms darstellt, und
- eine zweite, als Spannungs-Spannungs-Wandler wirkende Stufe (6b), welche die Spannungsdifferenz der ersten Stufe empfängt und die logische Ausgangsspannung (OUT) erzeugt.

3. Leseschaltung nach Anspruch 2,
dadurch gekennzeichnet, daß
sie einen zweiten Eingang (2b) aufweist, der an eine Referenzschaltung angeschlossen ist, wobei die erste Stufe (6a) einen Referenzstrom (Ib) erzeugt und die Spannungsdifferenz in Abhängigkeit von den relativen Werten des zweiten Stroms (Ia-Ic) und eines dritten Stroms (Ib-Id) erzeugt wird, der durch Umleitung eines Teils (Id) des Referenzstroms (Ib) zur Referenzleitung erhalten wird.

4. Leseschaltung nach Anspruch 2 oder 3,
dadurch gekennzeichnet, daß
die erste Stufe (6a) aufweist:
- einen ersten Zweig, der mindestens zwei erste Transistoren (12a, 14a) aufweist, die mit der ersten Stromquelle (4) in Reihe geschaltet sind, und der eine erste Spannung (VS1) erzeugt, die den Strom (Ia-Ic) darstellt, der durch die ersten Transistoren fließt, und
- einen zweiten Zweig, der eine zweite Stromquelle (10), die den Referenzstrom (Ib) erzeugt, und mindestens zwei zweite Transistoren (12b, 14b) aufweist, die mit der zweiten Stromquelle in Reihe geschaltet sind und eine zweite Spannung (VS2) erzeugen, die den Strom (Ib-Id) darstellt, der durch die zweiten Transistoren fließt.

5. Leseschaltung nach den Ansprüchen 3 und 4,
dadurch gekennzeichnet, daß
für jeden Zweig der Kanal des einen der Transistoren (12a, 12b) vom zweiten Strom (Ia-Ic) und der Kanal des anderen Transistors vom dritten Strom (Ib-Id) durchflossen wird, wobei die Gates auf einem gegebenen Potential (SEL) liegen und an ihren Source-Anschlüssen die erste und die zweite Spannung (VS1, VS2) vorliegen.

6. Leseschaltung nach einem der Ansprüche 3 bis 5,
dadurch gekennzeichnet, daß
die zweite Stufe (6b) des Wandlers eine unsymmetrische Differenzbildungs-Doppelstruktur ist, die so wirkt, daß die erzeugte Ausgangsspannung (OUT) einen ersten Wert annimmt, wenn der zweite Strom (Ia-Ic) und der dritte Strom (Ib-Id) gleich sind, und einen zweiten Wert annimmt, wenn sie verschieden sind.

## Claims

1. Read circuit (1) for a memory comprising:
- at least one first input (2a) for being connected to a bit line (BL) to which memory cells (CM1, CM2) are connected,
- an output (3) for producing an output logic potential (OUT),
- a current source (4) producing a first current (Ia), and
- a current to voltage converter (6) producing the output logic potential (OUT), this potential representing the value of a second current (Ia - Ic), obtained by diverting part (Ic) of the first current (Ia) to the bit line (BL) when one of the cells is read, so that, once the bit line is charged, the value of this second current (Ia - Ic) is determined solely by the state of the selected cell and is independent of the capacitive charge (CBL) of the bit line.

2. Circuit according to Claim 1, characterised in that the current to voltage converter comprises:
- a first current to voltage conversion stage (6a), the said first stage producing, from the second current (Ia - Ic), a potential difference (VS2 - VS1) representing the value of this second current, and
- a second voltage to voltage conversion stage (6b), receiving the potential difference of the first stage and producing the output logic potential (OUT).

3. Circuit according to Claim 2, characterised in that it comprises a second input (2b) for being connected to a reference circuit, the first stage (6a) producing a reference current (Ib), the potential difference being produced as a function of the relative values of the second current (Ia - Ib) and a third current (Ib - Id) obtained by diverting part (Id) of the reference current (Ib) to the reference line.

4. Circuit according to one of Claims 2 or 3, characterised in that the first stage (6a) comprises:
- a first branch, the said first branch comprising at least two first transistors (12a, 14a) connected in series with the first current source (4), and producing a first potential (VS1) representing the current (Ia - Ic) passing through the said first transistors, and
- a second branch, the said second comprising a second current source (10) producing the reference current (Ib) and at least two second transistors (12b, 14b) connected in series with the second current source, and producing a second potential (VS2) representing the current (Ib - Id) passing through the said second transistors.

5. Circuit according to Claims 3 and 4, characterised in that, for each branch, one of the transistors (12a, 12b) has the second (Ia - Ic) and third (Ib - Id) currents passing respectively through its channel, their control gates being at a given potential (SEL), and their sources producing the first and second potentials (VS1, VS2).

6. Circuit according to one of Claims 3 to 5, characterised in that the second stage (6b) of the converter is an unbalanced differential pair such that the output potential (OUT) produced has a first value when the second current (Ia - Ic) and third current (Ib - Id) are equal and has a second value when they are different.
